# EUROPEAN PATENT APPLICATION

(11) **EP 2 808 729 A1**
(43) Date of publication of application: **03.12.2014**
(21) Application number: 14162876.8
(22) Date of filing: 31.03.2014
(51) Int. Cl.: G02F 1/1333, G02F 1/1341, G02F 1/1339, G02F 1/1337

(54) **Display device and manufacturing method thereof**

(30) Priority: 30.05.2013 KR 20130061969
(71) Applicant: Samsung Display Co., Ltd., Gyeonggi-Do (KR)
(72) Inventor: Sung, Woo Yong, Seoul (KR); Kim, Yeun Tae, Gyeonggi-do (KR); Kim, Tae Gyun, Seoul (KR); Park, Jae Cheol, Gyeonggi-do (KR); Lee, Hyoung Sub, Gyeonggi-do (KR); Cha, Tae Woon, Seoul (KR)
(74) Representative: Mounteney, Simon James

(57) **Abstract**

A display device includes a substrate, a thin film transistor disposed on the substrate, and a pixel electrode electrically connected to the thin film transistor. The display device further includes a roof layer overlapping the pixel electrode with a cavity being positioned between the roof layer and the pixel electrode, the cavity having an opening. The display device further includes an alignment layer and a liquid crystal layer disposed inside the cavity. The display device further includes a plurality of bead members disposed at the opening and including a first bead member, a first portion of the first bead member being disposed inside the cavity, a second portion of the first bead member being disposed outside the cavity. The display device further includes an encapsulation layer overlapping the roof layer and overlapping the plurality of bead members.

## Description

### BACKGROUND

### (a) Technical Field

The present invention relates to a display device and a manufacturing method thereof.

### (b) Description of the Related Art

A liquid crystal display typically includes two field generating electrodes and a liquid crystal layer interposed therebetween. The liquid crystal display may apply a voltage to the field generating electrodes to control alignment of liquid crystal molecules of the liquid crystal layer through a generated electric field, thereby controlling polarization of incident light for displaying images.

The liquid crystal display may include a thin film transistor array panel and an opposite panel. The thin film transistor array panel may include a gate line for transferring a gate signal, a data line for transferring a data signal, a thin film transistor connected to the gate line and the data line, and a pixel electrode (which is one of the field generating electrodes) connected to the thin film transistor. The opposite panel may include a light blocking member, a color filter, and a common electrode (which is one of the field generating electrodes). In some cases, the light blocking member, the color filter, and the common electrode may be formed on the thin film transistor array panel.

Typically, two substrates are used for forming the thin film transistor array panel and the opposite panel, respectively. The two substrates may undesirably contribute to the weight, thickness, cost, and/or manufacturing time associated with the liquid crystal display.

The above information disclosed in this Background section is for enhancement of understanding of the background of the invention. The Background section may contain information that does not form the prior art that is already known in this country to a person of ordinary skill in the art.

### SUMMARY

Embodiments of the invention may be related to a display device that includes only one substrate, such that the weight, the thickness, the cost, and/or the manufacturing time associated with the device may be minimized. The display device may include supporting elements disposed at openings of cavities, such that the display device may have a robust structure. Embodiments of the invention may be related to a method for manufacturing the display device using only one substrate.

An embodiment of the invention may be related to a display device that includes a substrate, the substrate including a plurality of pixel areas. The display device may further include a thin film transistor disposed on the substrate. The display device may further include a pixel electrode electrically connected to the thin film transistor and disposed in the pixel area. The display device may further include a roof layer overlapping the pixel electrode with a plurality of microcavities being positioned between the roof layer and the pixel electrode, the microcavity having an injection hole. The display device may further include an alignment layer disposed inside the microcavity. The display device may further include a liquid crystal layer disposed inside the microcavity. The display device may further include a plurality of bead members disposed at the injection hole. The display device may further include an encapsulation layer overlapping the roof layer and overlapping the plurality of bead members.

A diameter of the bead member may be equal to or larger than a height of the microcavity.

The diameter of the bead member may be equal to or smaller than 110% of the height of the microcavity.

An area of the injection hole blocked by the plurality of bead members may be in a range of 1% to 80% of the entire area of the injection hole.

The display may include an alignment material layer formed of an alignment material used for forming the alignment layer, disposed outside the microcavity, and covering the plurality of bead members.

An area of the injection hole blocked by the plurality of bead members may be in a range of 80% to 100% of the entire area of the injection hole.

The plurality of bead members may be further disposed between the plurality of microcavities.

Viscosity of an encapsulation layer material used for forming the encapsulation layer may be 1000 cp or less.

The viscosity of the encapsulation layer material may be in a range of 30 cp to 100 cp.

An embodiment of the invention may be related to a method for forming a display device. The method may include the following steps: forming a thin film transistor on a substrate, the substrate including a plurality of pixel areas; forming a pixel electrode in the pixel area, the pixel electrode being electrically connected to the thin film transistor; forming a sacrificial layer that overlaps the pixel electrode; forming a roof layer that overlaps the sacrificial layer; exposing a part of the sacrificial layer; removing the sacrificial layer to form a plurality of microcavities between the pixel electrode and the roof layer, the microcavity having an injection hole; providing a mixture to the microcavity, the mixture including a plurality of bead members and at least one of an alignment material and a liquid crystal material; and forming an encapsulation layer that overlaps the roof layer and overlaps the plurality of bead members.

The bead member may be positioned at the injection hole. Alignment layers may be formed on the pixel electrode and below the roof layer.

A diameter of the bead member may be in a range of a height of the microcavity to 110% of the height of the microcavity.

An area of the injection hole blocked by the plurality of bead members may be in a range of 1% to 80% of the entire area of the injection hole.

The alignment material may cover the bead member.

The bead member may be positioned at the inj ection hole, and the liquid crystal material is provided into the microcavity by providing the mixture to the microcavity.

An area of the injection hole blocked by the plurality of bead members may be in a range of 80% to 100 % of the entire area of the injection hole.

The plurality of bead members may be further disposed between the plurality of microcavities.

The method may include removing a liquid crystal material positioned on the roof layer after forming a liquid crystal layer in the microcavity.

Viscosity of a material used for forming the encapsulation layer may be 1000 cp or less.

The mixture may include the plurality of bead members and the liquid crystal material.

An embodiment of the invention may be related to a display device that includes a substrate, the substrate including a plurality of pixel areas, the plurality of pixel areas including a first pixel area that corresponds to a first pixel of the display device. The display device may further include a thin film transistor disposed on the substrate. The display device may further include a first pixel electrode electrically connected to the thin film transistor and disposed in the first pixel area. The display device may further include a roof layer overlapping the first pixel electrode with a cavity being positioned between the roof layer and the first pixel electrode, the cavity having an opening. The display device may further include an alignment layer disposed inside the cavity. The display device may further include a liquid crystal layer disposed inside the cavity. The display device may further include a plurality of bead members disposed at the opening, the plurality of bead members including a first bead member, a first portion of the first bead member being disposed inside the cavity, a second portion of the first bead member being disposed outside the cavity. The display device may further include an encapsulation layer overlapping the roof layer and overlapping the plurality of bead members.

A diameter of the first bead member may be equal to or larger than a height of the cavity.

The diameter of the first bead member may be equal to or smaller than 110% of the height of the cavity.

An area of the opening blocked by the plurality of bead members may be in a range of 1% to 80% of the entire area of the opening.

The display device may include an alignment material layer formed of an alignment material used for forming the alignment layer, disposed outside the cavity, and covering the plurality of bead members. The alignment material layer may cover the second portion of the first bead member.

An area of the opening blocked by the plurality of bead members may be in a range of 80% to 100% of the entire area of the opening.

The display device may include a second pixel electrode disposed in the first pixel area. The plurality of bead members may be disposed between the first pixel electrode and the second pixel electrode.

The viscosity of an encapsulation layer material used for forming the encapsulation layer may be 1000 cp or less.

The viscosity of the encapsulation layer material may be in a range of 30 cp to 100 cp.

An embodiment of the invention may be related to a method for forming a display device. The method may include the following steps: forming a thin film transistor on a substrate, the substrate including a plurality of pixel areas, the plurality of pixel areas including a first pixel area that corresponds to a first pixel of the display device; forming a first pixel electrode in the first pixel area, the first pixel electrode being electrically connected to the thin film transistor; forming a sacrificial layer that overlaps the pixel electrode; forming a roof layer that overlaps the sacrificial layer; exposing a part of the sacrificial layer; removing the sacrificial layer to form a cavity between the first pixel electrode and the roof layer, the cavity having an opening; providing a mixture to the cavity, the mixture including a plurality of bead members and at least one of an alignment material and a liquid crystal material, wherein the plurality of bead members includes a first bead member, wherein at least one of a first portion of the alignment material and a first portion of the liquid crystal material is disposed inside the cavity, wherein at least one of a second portion of the alignment material and a second portion of the liquid crystal material is disposed outside the cavity, wherein a first portion of the first bead member is disposed inside the cavity, and wherein a second portion of the first bead member is disposed outside the cavity; and forming an encapsulation layer that overlaps the roof layer and overlaps the plurality of bead members.

The bead member may be positioned between the first portion of the alignment material and the second portion of the alignment material.

A diameter of the first bead member may be in a range of a height of the cavity to 110% of the height of the cavity.

An area of the opening blocked by the plurality of bead members may be in a range of 1% to 80% of the entire area of the opening.

The second portion of the alignment material may cover the second portion of the first bead member.

The first bead member may be positioned at the opening before the first portion of the liquid crystal material is provided into the cavity.

An area of the opening blocked by the plurality of bead members may be in a range of 80% to 100 % of the entire area of the injection hole. The first bead member may be position at the opening when or after the first portion of the liquid crystal material is provided into the cavity.

The method may include forming a second pixel electrode in the first pixel area. The plurality of bead members may be disposed between the first pixel electrode and the second pixel electrode.

The method may include removing the second portion of the liquid crystal material after the first portion of the liquid crystal layer has been provided in the cavity.

The viscosity of a material used for forming the encapsulation layer may be 1000 cp or less.

The mixture may include the plurality of bead members and the liquid crystal material.

An embodiment of the invention may be related a display device that may include the following elements: a substrate including a plurality of pixel areas; a thin film transistor formed on the substrate; a pixel electrode connected to the thin film transistor and formed in a pixel area of the plurality of pixel areas; a roof layer formed on the pixel electrode to be spaced apart from the pixel electrode with a microcavity therebetween; an alignment layer formed on the pixel electrode and below the roof layer; an injection hole formed in the roof layer so as to expose a part of the microcavity; a liquid crystal layer filling the microcavity; a plurality of bead members that includes a bead member formed in the injection hole; and an encapsulation layer formed on the roof layer so as to cover the injection hole to seal the microcavity.

A diameter of the bead member may be equal to or larger than a height of the microcavity.

The diameter of the bead member may be equal to or smaller than the height of the microcavity by 110%.

An area in which the plurality of bead members blocks the injection hole may be 1% or more and 80% or less of the entire area of the injection hole.

A layer formed of an alignment material used for forming the alignment layer may cover the bead member.

An area in which the bead member blocks the injection hole may be more than 80% and 100% or less of the entire area of the injection hole.

Some of the plurality of bead members may be disposed in a region between two injection holes that face each other.

Viscosity of the encapsulation layer may be 1000 cp or less.

The viscosity of the encapsulation layer may be 30 cp or more and 100 cp or less.

An embodiment of the invention may be related to a manufacturing method of a display device. The method may include the following steps: forming a thin film transistor on a substrate including a plurality of pixel areas; forming a pixel electrode connected to the thin film transistor in a pixel area of the plurality of pixel areas; forming a sacrificial layer on the pixel electrode; forming a roof layer on the sacrificial layer; exposing a part of the sacrificial layer; forming a microcavity between the pixel electrode and the roof layer by removing the sacrificial layer; supplying a mixture that includes an alignment material and a plurality of bead members (which includes a bead member) to the injection hole; forming a liquid crystal layer in the microcavity by injecting a liquid crystal material through the injection hole; and forming an encapsulation layer on the roof layer to seal the microcavity.

In the supplying of the alignment material, the bead member may be positioned in the injection hole, the alignment material may be injected into the microcavity, and alignment layers may be formed on the pixel electrode and below the roof layer.

A diameter of the bead member may be equal to or larger than a height of the microcavity, and may be equal to or smaller than the height of the microcavity multiplied by 110%.

An area in which the plurality of bead members blocks the injection hole may be 1% or more and 80% or less of the entire area of the injection hole.

A layer formed of an alignment material used for forming the alignment layer may cover the bead member.

In the forming of the liquid crystal layer, the bead member may be positioned in the injection hole, and the liquid crystal material may be injected into the microcavity, by supplying a mixture that includes a liquid crystal material and additional bead members to the injection hole.

An area in which the plurality of bead members and the additional bead members block the injection hole may be more than 80% and 100 % or less of the entire area of the injection hole.

In the forming of the liquid crystal layer, some bead members may be disposed in a region between two injection holes that face each other.

The viscosity of a material used for forming the encapsulation layer may be 1000 cp or less.

The manufacturing method of a display device may further include removing a portion of the liquid crystal material positioned on the roof layer after forming the liquid crystal layer.

An embodiment of the invention may be related to a manufacturing method of a display device. The method may include the following steps: forming a thin film transistor on a substrate including a plurality of pixel areas; forming a pixel electrode connected to the thin film transistor in the pixel area; forming a sacrificial layer on the pixel electrode; forming a roof layer on the sacrificial layer; exposing a part of the sacrificial layer; forming a microcavity between the pixel electrode and the roof layer by removing the sacrificial layer; forming a liquid crystal layer in the microcavity when the bead member is positioned in the injection hole and the liquid crystal material is injected into the microcavity, by supplying a mixture that includes a liquid crystal material and the bead member to the injection hole; and forming an encapsulation layer on the roof layer to seal the microcavity.

### BRIEF DESCRIPTION OF THE DRAWINGS

FIG. 1 is a plan view illustrating a display device according to an embodiment of the present invention.
FIG. 2 is a plan view illustrating one pixel of the display device according to an embodiment of the present invention.
FIG. 3 is a cross-sectional view illustrating a part of the display device taken along line III-III indicated in FIG. 1 according to an embodiment of the present invention.
FIG. 4 is a cross-sectional view illustrating a part of the display device taken along line IV-IV indicated in FIG. 1 according to an embodiment of the present invention
FIGS. 5 to 10 are process cross-sectional views illustrating a manufacturing method of the display device according to an embodiment of the present invention.
FIG. 11 is a plan view illustrating a display device according to an embodiment of the present invention.
FIG. 12 is a plan view illustrating one pixel of the display device according to an embodiment of the present invention.
FIG. 13 is a cross-sectional view illustrating a part of the display device taken along line XIII-XIII indicated in FIG. 11 according to an embodiment of the present invention.
FIGS. 14 to 17 are process cross-sectional views illustrating a manufacturing method of the display device according to an embodiment of the present invention.
FIGS. 18 to 20 are process cross-sectional views illustrating a manufacturing method of the display device according to an embodiment of the present invention.

### DETAILED DESCRIPTION OF THE EMBODIMENTS

The present invention will be described more fully hereinafter with reference to the accompanying drawings, in which embodiments of the invention are shown. As those skilled in the art would realize, the described embodiments may be modified in various different ways, all without departing from the spirit or scope of the present invention.

In the drawings, the thickness of layers, films, panels, regions, etc., may be exaggerated for clarity. Like reference numerals may designate like elements in the specification. When an element, such as a layer, film, region, or substrate, is referred to as being "on" another element, it can be directly on the other element, or one or more intervening elements may also be present. In contrast, when an element is referred to as being "directly on" another element, there are no intended intervening elements (except possible environmental elements such as air) present.

Although the terms first, second, etc. may be used herein to describe various signals, elements, components, regions, layers, and/or sections, these signals, elements, components, regions, layers, and/or sections should not be limited by these terms. These terms may be used to distinguish one signal, element, component, region, layer, or section from another signal, region, layer, or section. Thus, a first signal, element, component, region, layer, or section discussed below may be termed a second signal, element, component, region, layer, or section without departing from the teachings of the present invention. The description of an element as a "first" element may not require or imply the presence of a second element or other elements. The terms first, second, etc. may also be used herein to differentiate different categories of elements. For conciseness, the terms first, second, etc. may represent first-type (or first-category), second-type (or second-category), etc., respectively.

In the description, the term "connect" may mean "electrically connect"; the term "insulate" may mean "electrically insulate".

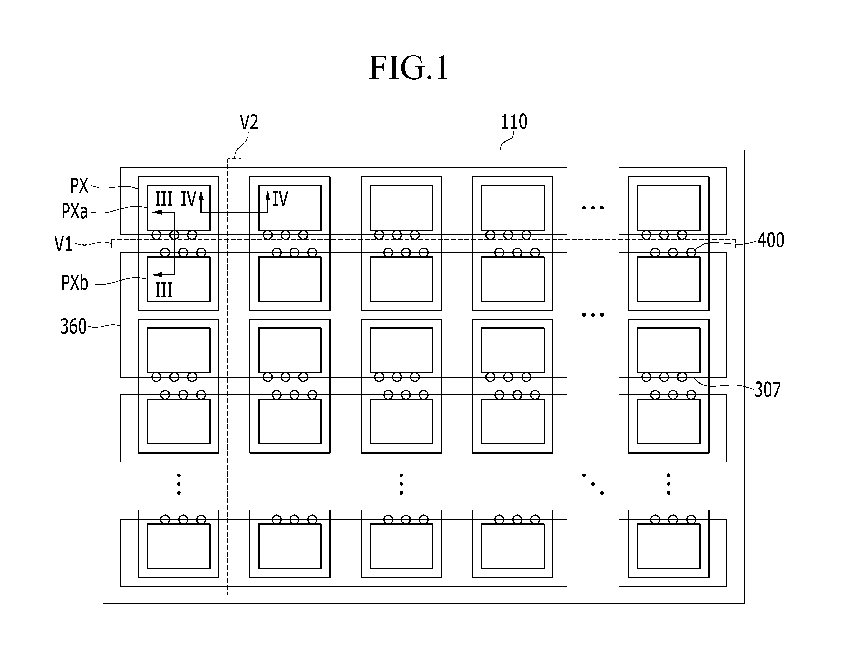

FIG. 1 is a plan view illustrating a display device according to an embodiment of the present invention. For clear illustration, FIG. 1 illustrates only some constituent elements.

The display device includes a substrate 110 and a roof layer 360 that overlaps the substrate 110. The substrate may be made of at least one of glass and plastic.

The substrate 110 includes a plurality of pixel areas PX. The plurality of pixel areas PX includes a plurality of pixel rows and a plurality of pixel columns that form a matrix (e.g., a rectangular array). Each pixel area PX may include a first subpixel area PXa and a second subpixel area PXb. The first subpixel area PXa and the second subpixel area PXb may be substantially vertically disposed and/or may be aligned in a pixel column direction.

A first valley V1 is positioned between the first subpixel area PXa and the second subpixel area PXb in a pixel row direction, and a second valley V2 is positioned between two immediately neighboring pixel columns.

Portions of the roof layer 360 may be formed along the plurality of pixel rows. In an embodiment, the first valley V1 may be positioned between two immediately neighboring portions of the roof layer 360, and may enable access to injection holes 307 that are positioned below the roof layer 360 during manufacturing of the display device.

Each of the first subpixel area PXa and the second subpixel area PXb may be associated with an injection hole 307, which may be an opening that allows access to a microcavity 305. An injection hole 307 may correspond to a lower side of the first subpixel area PXa, and an injection hole 307 may correspond to an upper side of the second subpixel area PXb. The two injection holes 307 may face each other.

A bead member 400 may be formed at an injection hole 307. In an embodiment, at least one bead member 400 may be disposed at each injection hole 307. In an embodiment, three bead members 400 may be disposed at the injection hole 307 formed in the first subpixel area PXa, and three bead members 400 may be disposed at the injection hole 307 formed in the second subpixel area PXb. In an embodiment, the number of bead members 400 disposed at the injection hole 307 associated with the first subpixel area PXa may be different from the number of bead members 400 disposed at the injection hole 307 associated with the second subpixel area PXb. In an embodiment, bead members 400 may be disposed at some injection holes 307, and no bead members 400 may be disposed at the remaining injection holes 307.

A pixel of the display device is described with reference to FIGS. 1 to 4.

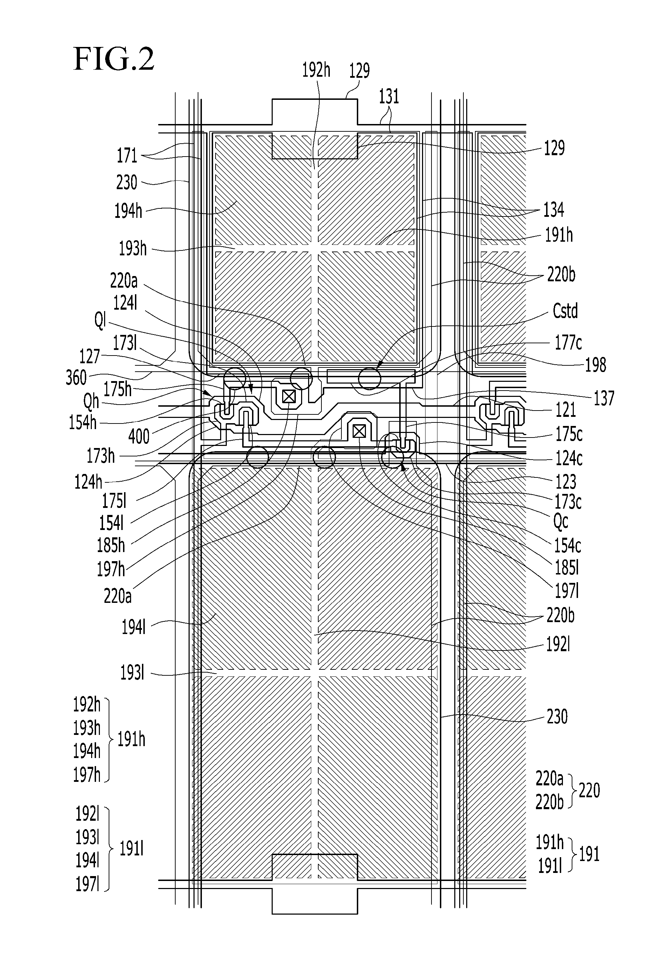

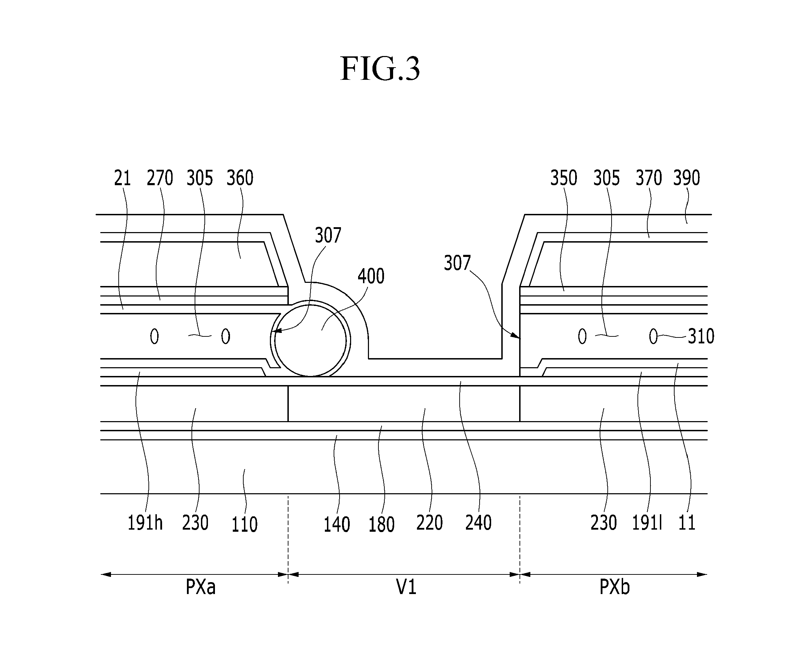

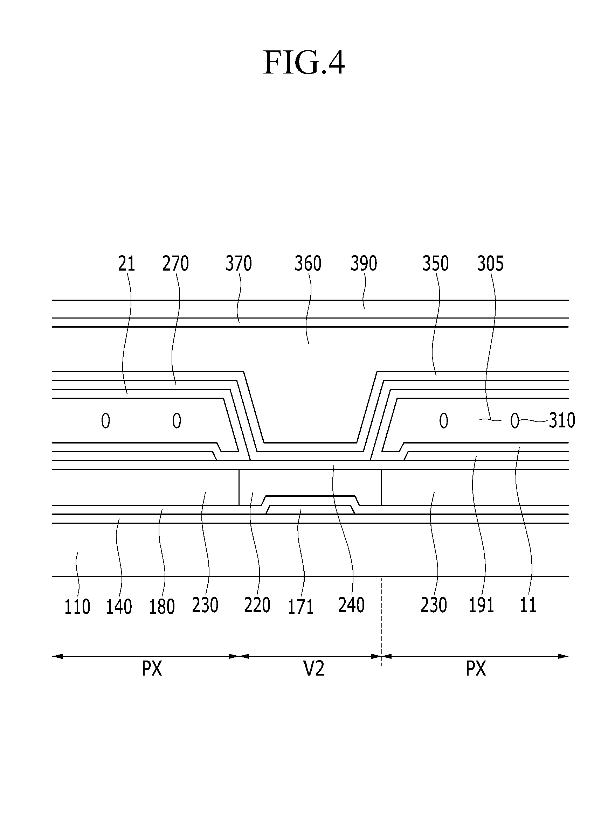

FIG. 2 is a plan view illustrating the pixel of the display device according to the exemplary embodiment of the present invention. FIG. 3 is a cross-sectional view illustrating a part of the display device taken along line III-III indicated in FIG. 1 according to an embodiment of the present invention. FIG. 4 is a cross-sectional view illustrating a part of the display device taken along line IV-IV indicated in FIG. 1 according to an embodiment of the present invention.

Referring to FIGS. 1 to 4, the pixel may be associated with a plurality of gate conductors, including a gate line 121, a step-down gate line 123, and a storage electrode line 131, which may be formed on the substrate 110.

The gate line 121 and the step-down gate line 123 may mainly extend in a horizontal direction (or pixel row direction parallel to the first valley V1) and may transfer gate signals. The gate conductors may further include a first gate electrode 124h and a second gate electrode 124I that protrude substantially upward and downward, respectively, from the gate line 121. The gate conductors may further include a third gate electrode 124c that protrudes upward from the step-down gate line 123. The first gate electrode 124h and the second gate electrode 124I may be substantially aligned with each other in the pixel column direction and may form one enlarged portion of the gate line 121. The gate electrodes 124h, 1241, and 124c may have one or more other protrusion configurations.

Each storage electrode line 131 mainly extends in a horizontal direction (e.g., the pixel row direction) to transfer a predetermined voltage such as a common voltage Vcom. The storage electrode line 131 includes storage electrodes 129 that protrude upward and downward, a pair of vertical portions 134 that extends toward the gate line 121 and extends substantially vertical to the gate line 121, and a horizontal portion 127 that connects ends of the vertical portions 134. The horizontal portion 127 includes a capacitor electrode 137 that expands toward the gate line 121.

A gate insulating layer 140 may be formed on (and may cover) the gate conductors 121, 123, 124h, 1241, 124c, and 131. The gate insulating layer 140 may be made of an inorganic insulating material such as at least one of silicon nitride (SiNx) and silicon oxide (SiOx). The gate insulating layer 140 may have a single layer structure or a multiple layer structure.

A first semiconductor 154h, a second semiconductor 1541, and a third semiconductor 154c are formed on the gate insulating layer 140. The first semiconductor 154h may be positioned on the first gate electrode 124h, the second semiconductor 1541 may be positioned on the second gate electrode 124I, and the third semiconductor 154c may be positioned on the third gate electrode 124c. The first semiconductor 154h and the second semiconductor 1541 may be connected to each other, and the second semiconductor 1541 and the third semiconductor 154c may be connected to each other. The first semiconductor 154h may overlap an extended portion of the data line 171. The semiconductors 154h, 1541, and 154c may be made of one or more of amorphous silicon, polycrystalline silicon, metal oxide, etc.

Ohmic contacts (not illustrated) may be formed on the semiconductors 154h, 1541, and 154c, respectively. The ohmic contacts may be made of silicide or a material (such as n+ hydrogenated amorphous silicon) in which an n-type impurity is doped at high concentration.

The pixel may be associated with a plurality of data conductors, including a data line 171, a first source electrode 173h, a second source electrode 1731, a third source electrode 173c, a first drain electrode 175h, a second drain electrode 1751, and a third drain electrode 175c. Some of the data conductors may be formed on the semiconductors 154h, 1541, and 154c.

The data line 171 may transfer a data signal. The data line may mainly extend in a vertical direction (e.g., the pixel column direction) and may cross the gate line 121 and the step-down gate line 123. The data line 171 may include (or may be connected to) the first source electrode 173h and the second source electrode 1731, which correspond to the first gate electrode 124h and the second gate electrode 1241, respectively, and are connected with each other.

Each of the first drain electrode 175h, the second drain electrode 1751, and the third drain electrode 175c may include a relatively wider portion and a relatively narrower rod-shaped end portion connected to the relatively wider portion. The rod-shaped end portions of the first drain electrode 175h and the second drain electrode 1751 are partially surrounded by the first source electrode 173h and the second source electrode 1731, respectively. The relatively wider portion of the second drain electrode 1751 is connected to a third source electrode 173c, which is curved in a `U'-lettered shape. A wide end portion 177c of the third drain electrode 175c overlaps the capacitor electrode 137 to form a step-down capacitor Cstd, and the rod-shaped end portion of the third drain electrode 175c is partially surrounded by the third source electrode 173c.

The first gate electrode 124h, the first source electrode 173h, and the first drain electrode 175h form a first thin film transistor Qh together with the first semiconductor 154h. The second gate electrode 1241, the second source electrode 1731, and the second drain electrode 1751 form a second thin film transistor QI together with the second semiconductor 1541. The third gate electrode 124c, the third source electrode 173c, and the third drain electrode 175c form a third thin film transistor Qc together with the third semiconductor 154c.

The first semiconductor 154h, the second semiconductor 1541, and the third semiconductor 154c may be connected to each other. One or more of the semiconductors 154h, 1541, and 154c may have substantially the same planar shape as one or more of the data conductors 173h, 1731, 173c, 175h, 1751, and 175c and one or more of the associated ohmic contacts, except for one or more channel regions between one or more of the source electrodes 173h, 1731, and 173c and one or more of the drain electrodes 175h, 1751, and 175c.

In the first semiconductor 154h, an exposed portion that is not covered by the first source electrode 173h and the first drain electrode 175h is disposed between the first source electrode 173h and the first drain electrode 175h in the plan view of the display device. In the second semiconductor 1541, an exposed portion that is not covered by the second source electrode 1731 and the second drain electrode 1751 is disposed between the second source electrode 1731 and the second drain electrode 1751 in the plan view of the display device. In the third semiconductor 154c, an exposed portion that is not covered by the third source electrode 173c and the third drain electrode 175c is disposed between the third source electrode 173c and the third drain electrode 175c.

A passivation layer 180 is formed on the data conductors 171, 173h, 1731, 173c, 175h, 1751, and 175c and the portions of the semiconductors 154h, 1541, and 154c exposed between the respective source electrodes 173h, 1731, and 173c and the respective drain electrodes 175h, 1751, and 175c. The passivation layer 180 may be made of an organic insulating material or an inorganic insulating material. The passivation may have a single layer structure or a multiple layer structure.

A color filter 230 in each pixel area PX is formed on the passivation layer 180. Each color filter 230 may display one of primary colors and/or may display white. In an embodiment, the primary colors may be three primary colors of red, green and blue. In an embodiment the primary colors may include cyan, magenta, and yellow. In an embodiment, a color filter 230 may extend in a column direction along a space between immediately adj acent data lines 171.

A light blocking member 220 is formed in a region between immediately adjacent color filters 230 and/or between separated portions of color filters. The light blocking member 220 is formed on a boundary of the pixel area PX and formed on the thin film transistors to prevent light leakage. A color filter 230 may include a first portion formed in the first subpixel area PXa and may include a second portion formed in the second subpixel area PXb. The light blocking member 220 may include a portion that is formed between the first subpixel area PXa and the second subpixel area PXb to cover the transistors.

The light blocking member 220 includes a horizontal light blocking member 220a that extends along the gate line 121 and the step-down gate line 123 and covers the first thin film transistor Qh, the second thin film transistor QI, and the third thin film transistor Qc. The light blocking member 220 further includes a vertical light blocking member 220b that extends along the data line 171. The horizontal light blocking member 220a overlap the first valley V1. The vertical light blocking member 220b may overlap the second valley V2. The color filter 230 and the light blocking member 220 may directly contact each other in a same layer of the display device and may both directly contact the passivation layer 180.

A first insulating layer 240 may be formed on the color filter 230 and the light blocking member 220. The first insulating layer 240 may be made of an inorganic insulating material such as at least one of silicon nitride (SiNx) and silicon oxide (SiOx). The first insulating layer 240 serves to protect the color filter 230 (which may be made of an organic material) and the light blocking member 220. In an embodiment, the first insulating layer 240 may be omitted.

In the first insulating layer 240, the light blocking member 220, and the passivation layer 180, a first contact hole 185h and a second contact holes 1851 are formed.

A pixel electrode 191 is formed on the first insulating layer 240. The pixel electrode 191 may be made of a transparent metal material such as at least one of indium tin oxide (ITO) and indium zinc oxide (IZO). The pixel electrode 191 may be connected to drain electrodes through the contact holes 185h and 1851.

The pixel electrode 191 includes a first subpixel electrode 191h and a second subpixel electrode 1911, which are separated from each other with the gate line 121 and the step-down gate line 123 being disposed substantially between the subpixel electrodes 191h and 1911. to the subpixel electrodes may be substantially aligned with each other in a column direction. The first subpixel electrode 191h and the second subpixel electrode 1911 may be separated from each other with the first valley V1 being disposed therebetween in a plan view of the display device. The first subpixel electrode 191h is positioned in the first subpixel area PXa, and the second subpixel electrode 1911 is positioned in the second subpixel area PXb.

The first subpixel electrode 191h and the second subpixel electrode 1911 are connected to the first drain electrode 175h and the second drain electrode 1751 through the first contact hole 185h and the second contact hole 1851, respectively. Accordingly, when the first thin film transistor Qh and the second thin film transistor Ql are turned on, the first subpixel electrode 191h and the second subpixel electrode 1911 receive data voltages from the first drain electrode 175h and the second drain electrode 1751.

An overall shape of each of the first subpixel electrode 191h and the second subpixel electrode 1911 may be substantially a quadrangle. The first subpixel electrode 191h and the second subpixel electrode 1911 include cross stems. The cross stems include horizontal stems 193h and 1931 and vertical stems 192h and 1921 that cross the horizontal stems 193h and 1931, respectively. The first subpixel electrode 191h and the second subpixel electrode 1911 may further include a plurality of minute branches 194h and 1941 and may further include protrusions 197h and 1971 protruding upward or downward from edge sides of the subpixel electrodes 191h and 1911, respectively.

Each of the subpixel electrodes 191h and 1911 of the pixel electrode 191 is divided into four sub-regions by an associated one of the horizontal stems 193h and 1931 and an associated one of the vertical stems 192h and 1921. The minute branches 194h and 1941 obliquely extend from the horizontal stems 193h and 1931 and the vertical stems 192h and 1921, extending at an angle of approximately 45 degrees or 135 degrees with respect to the gate line 121 or the horizontal stems 193h and 1931. In an embodiment, directions in which the minute branches 194h and 1941 of the two adjacent sub-regions extend may be perpendicular to each other.

The first subpixel electrode 191h may include an outer stem that surrounds at least some elements of the first subpixel electrode 191. The second subpixel electrode 1911 may include horizontal portions positioned at an upper end and a lower end of the second subpixel electrode 1911. The pixel electrode 191 may include left and right vertical portions 198 positioned at the left and the right of the first subpixel electrode 191h. The left and right vertical portions 198 may prevent a capacitive binding (or coupling) between the data line 171 and the first subpixel electrode 191h.

The layout form of the pixel area, the structure of the thin film transistor, and the shape of the pixel electrode described above are examples and may be modified in various embodiments.

A common electrode 270 may overlap the pixel electrode 191 and may be spaced from the pixel electrode 191 at a predetermined distance. A microcavity 305 is formed between the pixel electrode 191 and the common electrode 270. The microcavity 305 may be substantially surrounded by at least one of the pixel electrode 191 and the common electrode 270. A width and an area of the microcavity 305 may be configured according to a size and resolution of the display device.

In an embodiment, an insulating layer may be disposed between a common electrode 270 and a pixel electrode 191, and a microcavity 305 may be formed between the common electrode 270 and the insulating layer.

The common electrode 270 may be made of a transparent metal material such as at least one of indium tin oxide (ITO) and indium zinc oxide (IZO). A predetermined voltage may be applied to the common electrode 270, and an electric field may be generated between the pixel electrode 191 and the common electrode 270.

A first alignment layer 11 is formed on the pixel electrode 191. The first alignment layer 11 may also be formed directly on a portion of the first insulating layer 240 that is not covered by the pixel electrode 191.

A second alignment layer 21 is formed on the common electrode and is formed between the common electrode 270 and the first alignment layer 11.

The first alignment layer 11 and the second alignment layer 21 may be vertical alignment layers and may be made of one or more alignment materials, such as one or more of polyamic acid, polysiloxane, and polyimide. The alignment layers 11 and 21 may be connected to each other at the edge of the pixel area PX.

A liquid crystal layer that includes liquid crystal molecules 310 is formed in the microcavity 305 and is positioned between the pixel electrode 191 and the common electrode 270. The liquid crystal molecules 310 may have negative dielectric anisotropy and may be oriented in a direction that is substantially perpendicular to the substrate 110 (i.e., in vertical alignment) when no electric field is applied to the pixel electrode 191.

The first subpixel electrode 191h and the second subpixel electrode 1911 to which the data voltages are applied may generate an electric field together with a common electrode 270 to determine directions of the liquid crystal molecules 310The luminance of the light that is transmitted through the liquid crystal layer may be substantially determined by the directions of the liquid crystal molecules 310.

A second insulating layer 350 may be formed on the common electrode 270. The second insulating layer 350 may be made of an inorganic insulating material such as at least one of silicon nitride (SiNx) and silicon oxide (SiOx). In an embodiment, the second insulating layer 350 may be omitted.

A roof layer 360 is formed on the second insulating layer 350. The roof layer 360 may be made of an organic material. The microcavity 305 is formed below the roof layer 360, and the roof layer 360 is hardened by a curing process to maintain a shape of the microcavity 305. The microcavity 305 may be positioned between the roof layer 360 and the pixel electrode 191.

The roof layer 360 is formed in each pixel area PX and the second valley V2 along a pixel row, and is not formed in the first valley V1. That is, the roof layer 360 is not formed between the first subpixel area PXa and the second subpixel area PXb. The microcavity 305 is formed below each roof layer 360 in each of the first subpixel area PXa and the second subpixel area PXb. In the second valley V2, a portion of the roof layer 360 is disposed between two portions of the microcavity 305.. A thickness of the portion of the roof layer 360 positioned at the second valley V2 may be larger than a thickness of other portions of the roof layer 360 positioned in each of the first subpixel area PXa and the second subpixel area PXb. An upper surface and sides of the microcavity 305 may be covered by the roof layer 360.

An injection hole 307 for exposing a part of the microcavity 305 is formed in the roof layer 360. Injection holes 307 may face each other at the edges of the first subpixel area PXa and the second subpixel area PXb. An injection hole 307 may correspond to a lower side of the first subpixel area PXa to allow access to a first portion of the microcavity 305 that overlaps the first subpixel electrode 191h. An injection hole 307 may correspond to the upper side of the second subpixel area PXb allow access to a second portion of the microcavity 305 that overlaps the second subpixel electrode 1911.

Since the microcavity 305 is exposed by the injection hole 307, an aligning agent and/or a liquid crystal material may be injected into the microcavity 305 through the injection hole 307.

A bead member 400 is formed at the injection hole 307. In an embodiment, the bead member 400 has a globular shape, a part of the bead member 400 is positioned inside the microcavity 305, and the rest of the bead member 400 is positioned outside the microcavity 305. A proportion of a first bead member 400 positioned inside a microcavity 305 may be different from a proportion of a second bead member 400 positioned inside the microcavity 305. A proportion of a first bead member 400 positioned inside a first portion of a microcavity 305 that overlaps the first subpixel electrode 191h may be different from a proportion of a second bead member 400 positioned inside a second portion of the microcavity 305 that overlaps the second subpixel electrode 1911. Proportions of bead members 400 disposed inside the microcavity may (slightly) vary according to the configuration of the area between the first subpixel area PXa and the second subpixel area PXb. Bead members 400 may be aligned or misaligned in the column direction. Bead members 400 associated with the first subpixel area may be aligned or misaligned in the row direction. Bead members 400 associated with the second subpixel area may be aligned or misaligned in the row direction.

A height of a bead member 400 may be larger than or substantially equal to a height of the microcavity 305. Each bead member may be fixed (or attached) to the injection hole 307 and may directly contact the edge of the injection hole 307. In an embodiment of the present invention, the portion of the bead member 400 that is disposed inside the microcavity 305 may be disposed between at least one of a portion of the first alignment layer 11, the first insulating layer 240, the color filter 230, the passivation layer 180, the gate insulating layer 140, and the substrate 110 and at least one of a portion of the second alignment layer 21, an edge of the common electrode 270, an edge of the second insulating layer 350, and an edge of the roof layer 360. Advantageously, the bead member may sufficiently support the edge of the roof layer 360 at the injection hole 307, a possible sagging phenomenon at the edge of the roof layer 360 may be substantially prevented or minimized, and a robust structure of the display device may be provided.

A diameter of the bead member 400 may be equal to or larger than the height of the microcavity 305. If the diameter of the bead member 400 were smaller than the height of the microcavity 305, the bead member 400 might complete move to the inside of the microcavity 305. If the bead member 400 were positioned completely inside of the microcavity 305 in a display area of the display device, the bead member 400 might substantially influence light transmission, such that the displayed image might be adversely affected. In an embodiment, the diameter of the bead member 400 may be equal to or larger than the height of the microcavity 305 so that the bead member 400 does not completely enter the inside of the microcavity 305.

The diameter of the bead member 400 may be equal to or smaller than 110% of the height of the microcavity 305. If the diameter of the bead member 400 were much larger than the height of the microcavity 305, the bead member 400 might not be sufficiently fixed to the injection hole 307, and/or the bead member 400 might not have a sufficient portion disposed inside the microcavity 305 to sufficiently support the roof layer 360.

The outer surface of the bead member 400 may be surrounded by the alignment materials used for forming the first alignment layer 11 and the second alignment layer 21. That is, the alignment material may cover the bead member 400. In a process of forming the first alignment layer 11 and the second alignment layer 21, when the alignment material and the bead member 400 are mixed with each other to be supplied to the injection hole 307, a portion of the alignment material may enter the microcavity 305 to form the alignment layers 11 and 21, and another portion of the alignment material may remain on the surface of the bead member 400. As the alignment material cures, the bead member 400 may serve to be firmly fixed to the injection hole 307.

The bead member 400 may partially block the injection hole 307 without completely blocking the injection hole 307. Liquid crystal material may be injected into the microcavity through portions of the injection hole 370 that are not blocked by the bead member 400. In an embodiment, the portion of the injection hole 307 that is blocked by the bead member 400 may be in a range of 1% to 80% of the injection hole 307.

A third insulating layer 370 may be formed on the roof layer 360. The third insulating layer 370 may be made of an inorganic insulating material such as at least one of silicon nitride (SiNx) and silicon oxide (SiOx). The third insulating layer 370 may be formed to cover the top and the sides of the roof layer 360. The third insulating layer 370 serves to protect the roof layer 360 (which may be made of an organic material). In an embodiment, the third insulating layer 370 may be omitted.

An encapsulation layer 390 may be formed on the third insulating layer 370. The encapsulation layer 390 is formed to cover the injection hole 307, especially where portions of the microcavity 305 that are exposed (e.g., portions of microcavity 305 not sealed by bead members 400). The encapsulation layer 390 may seal the microcavity 305 so that the liquid crystal molecules 310 in the microcavity 305 are retained inside microcavity 305 without undesirable leakage. In an embodiment, the encapsulation layer 390 may directly contact some of the liquid crystal molecules 310, and the encapsulation layer 390 may be made of a material that does not substantially react with the liquid crystal molecules 310. For example, the encapsulation layer 390 may be made of parylene and/or one or more materials having analogous properties.

In an embodiment of the present invention, the bead members 400 partially block the partial region of the injection hole 307, such that material of the encapsulation layer 390 is less likely to enter the microcavity 305. If the injection hole 307 were completely unblocked, in order to prevent the material of the encapsulation layer 390 from penetrating into the microcavity 305, the material of the encapsulation layer 390 might need to have a sufficiently high viscosity. If the viscosity of the material of the encapsulation layer 390 were substantially high, flatness and/or thickness of the encapsulation layer 390 might not be sufficiently uniform. In an embodiment of the present invention, since the injection hole 307 is partially blocked by the bead member 400, the viscosity of the encapsulation layer 390 may be substantially minimized. Advantageously, the encapsulation layer 390 may be satisfactorily uniform. In an embodiment, the viscosity of the material of the encapsulation layer 390 may be 1000 cp or less. In an embodiment, the viscosity of the material of the encapsulation layer 390 may be in a range of 30 cp to 100 cp.

The encapsulation layer 390 may have a multilayer structure, such as a double layer structure or a triple layer structure. The double layer structure may include two layers made of different materials. The triple layer structure may include three layers, wherein materials of adjacent layers are different from each other. For example, the encapsulation layer 390 may include a layer made of an organic insulating material and may include a layer made of an inorganic insulating material.

Although not illustrated, polarizers may be further formed on the upper and lower surfaces of the display device. The polarizers may include a first polarizer and a second polarizer. The first polarizer may be attached onto the lower side of the substrate 110, and the second polarizer may be attached onto the encapsulation layer 390.

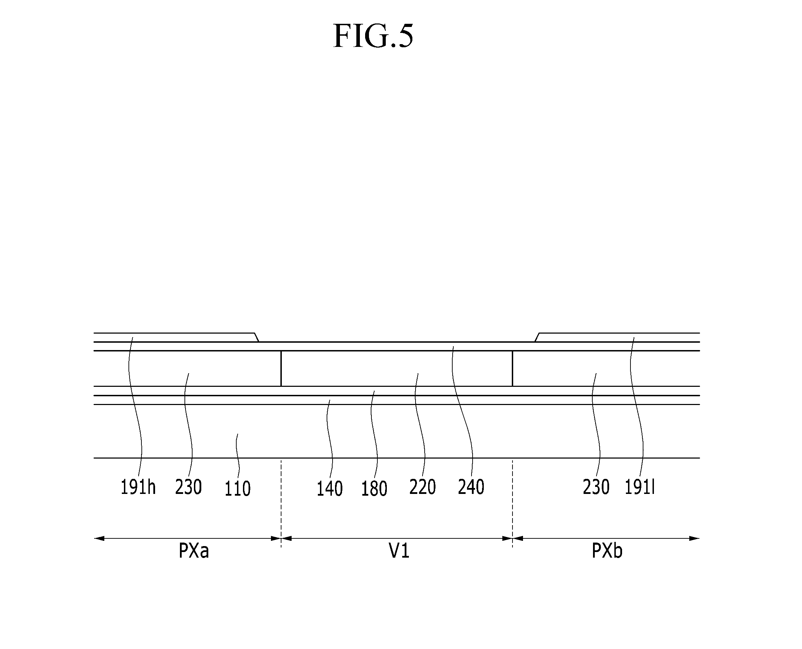

FIGS. 5 to 10 are process cross-sectional views illustrating a manufacturing method of a display device according to an embodiment of the present invention. The display device may be substantially analogous to the display device discussed with reference to FIGS. 1 to 4.

A gate line 121 and a step-down gate line 123 extending in a first direction are formed on a substrate 110 made of glass or plastic. A first gate electrode 124h, a second gate electrode 1241, and a third gate electrode 124c may protrude from the gate line 121.

In the process of forming the gate lines 121 and 123, a storage electrode line 131 may also be formed together and may be spaced apart from the gate line 121, the step-down gate line 123, and the gate electrodes 124h, 1241, and 124c.

Subsequently, a gate insulating layer 140 may be formed on the entire surface of the substrate 110 and may cover the gate line 121, the step-down gate line 123, the gate electrodes 124h, 1241, and 124c, and the storage electrode line 131. The gate insulating layer 140 may be formed using an inorganic insulating material such as silicon oxide (SiOx) or silicon nitride (SiNx). The gate insulating layer 140 may have a single layer structure or a multiple layer structure.

Subsequently, a first semiconductor 154h, a second semiconductor 1541, and a third semiconductor 154c are formed by depositing a semiconductor material, such as amorphous silicon, polycrystalline silicon, and/or metal oxide, on the gate insulating layer 140 and then patterning the deposited semiconductor material. The first semiconductor 154h may be positioned on the first gate electrode 124h, the second semiconductor 1541 may be positioned on the second gate electrode 124I, and the third semiconductor 154c may be positioned on the third gate electrode 124c.

Subsequently, a data line 171 extending in a second direction is formed by depositing a metal material and then patterning the deposited metal material. The metal material may have a single layer structure or a multiple layer structure.

A first source electrode 173h protruding above the first gate electrode 124h from the data line 171 and a first drain electrode 175h spaced apart from the first source electrode 173h are formed when the data line 171 is formed. A second source electrode 1731 connected with the first source electrode 173h and a second drain electrode 1751 spaced apart from the second source electrode 1731 are formed when the data line 171 is formed. A third source electrode 173c connected to the second drain electrode 1751 and a third drain electrode 175c spaced apart from the third source electrode 173c are formed when the data line 171 is formed.

The semiconductors 154h, 1541, and 154c, the data line 171, the source electrodes 173h, 1731, and 173c, and the drain electrodes 175h, 1751, and 175c may be formed by sequentially depositing a semiconductor material and a metal material and then patterning the semiconductor material and the metal material at the same time. In an embodiment, a portion of the first semiconductor 154h may extend to overlap a portion of the data line 171.

The gate electrodes 124h, 1241, 124c, the source electrodes 173h, 1731, 173c, and the drain electrodes 175h, 1751, 175c may form thin film transistors (TFTs) Qh, Ql, Qc together with the semiconductors 154h, 1541, 154c.

Subsequently, a passivation layer 180 is formed on the data line 171, the source electrodes 173h, 1731, and 173c, the drain electrodes 175h, 1751, and 175c, and portions of the semiconductors 154h, 1541, and 154c exposed between the respective source electrodes 173h, 1731, 173c and the respective drain electrodes 175h, 1751, 175c. The passivation layer 180 may be made of an organic insulating material or an inorganic insulating material, and may have a single layer structure or a multiple layer structure.

Subsequently, a color filter 230 is formed in each pixel area PX on the passivation layer 180. The color filter 230 is formed in each of the first subpixel area PXa and the second subpixel area PXb, and may not be formed at a first valley V1. Color filters 230 having the same color may be formed in a column direction in the plurality of pixel areas PX. In an embodiment, the color filters 230 have three colors, a first colored color filter 230 may be first formed, and then a second colored color filter 230 may be formed by shifting a mask. Subsequently, the second colored color filter 230 may be formed, and then a third colored color filter may be formed by shifting the mask.

Subsequently, a light blocking member 220 is formed at a boundary of each pixel area PX. The light blocking member 220 may overlap the passivation layer 180 and the thin film transistors. A portion of the light blocking member 220 may be formed at the first valley V1 positioned between the first subpixel area PXa and the second subpixel area PXb.

In an embodiment, the light blocking member 220 is formed after forming the color filters 230. In an embodiment, the light blocking member 220 is formed before formation of the color filters 230.

Subsequently, a first insulating layer 240 made of an inorganic insulating material such as silicon nitride (SiNx) and/or silicon oxide (SiOx) is formed on the color filter 230 and the light blocking member 220.

Subsequently, a first contact hole 185h is formed by etching the passivation layer 180, the light blocking member 220, and the first insulating layer 240 so as to expose a part of the first drain electrode 175h, and a second contact hole 1851 is formed so as to expose a part of the second drain electrode 1751.

Subsequently, a first subpixel electrode 191h is formed in the first subpixel area PXa, and a second subpixel electrode 1911 is formed in the second subpixel area PXb, by depositing and patterning a transparent metal material such as indium tin oxide (ITO) and/or indium zinc oxide (IZO) on the first insulating layer 240. The first subpixel electrode 191h and the second subpixel electrode 1911 are separated from each other with the first valley V1 being disposed therebetween. The first subpixel electrode 191h is connected to the first drain electrode 175h through the first contact hole 185h, and the second subpixel electrode 1911 is connected to the second drain electrode 1751 through the second contact hole 1851.

Horizontal stems 193h and 1931, and vertical stems 192h and 1921 crossing the horizontal stems 193h and 1931 are formed in the first subpixel electrode 191h and the second subpixel electrode 1911. A plurality of minute branches 194h and 1941, which obliquely extend from the horizontal stems 193h and 1931 and the vertical stems 192h and 1921, is formed.

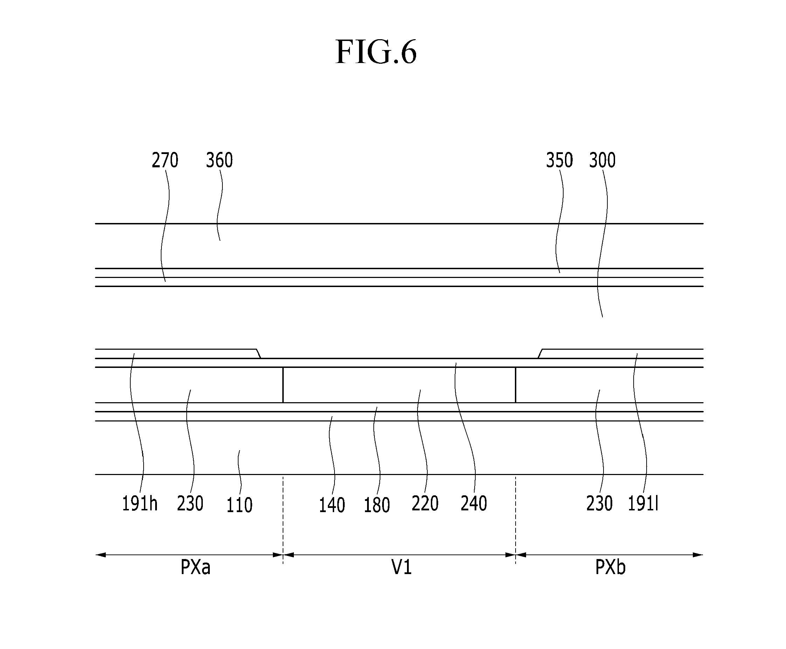

As illustrated in FIG. 6, a sacrificial layer 300 is formed by coating a photosensitive organic material on the pixel electrode 191 and performing a photolithography process.

Sacrificial layers 300 are formed to be connected to each other along the plurality of pixel columns. That is, each sacrificial layer 300 is formed to cover a pixel area PX and to cover the first valley V1 positioned between the first subpixel area PXa and the second subpixel area PXb.

Subsequently, a common electrode 270 is formed by depositing a transparent metal material such as indium tin oxide (ITO) and/or indium zinc oxide (IZO) on the sacrificial layer 300.

Subsequently, a second insulating layer 350 may be formed on the common electrode 270 using an inorganic insulating material such as silicon oxide and/or silicon nitride.

Subsequently, a roof layer 360 is formed on the second insulating layer 350 using an organic material.

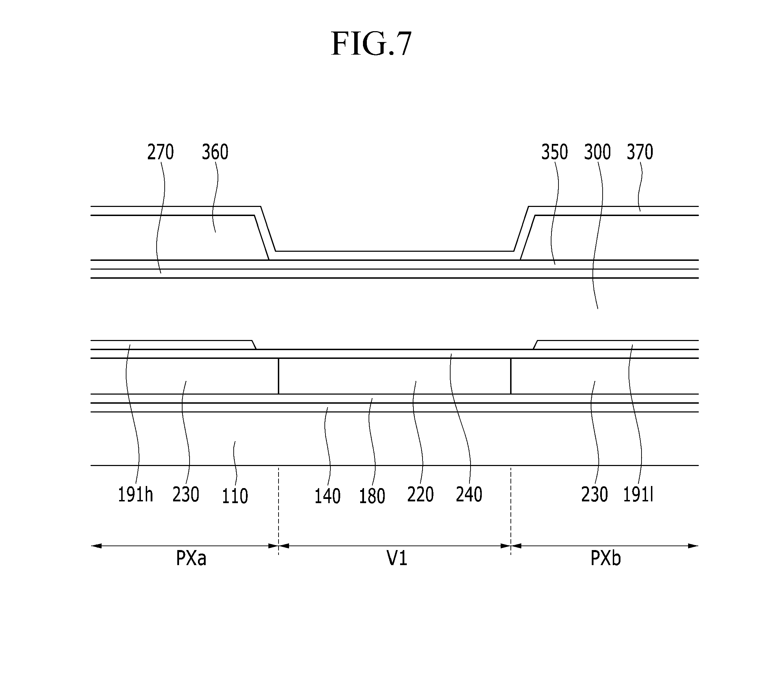

As illustrated in FIG. 7, a portion of the roof layer 360 positioned at the first valley V1 may be removed by patterning the roof layer 360. As a result, portions of the roof layer 360 may be formed to be connected to each other along a plurality of pixel rows.

Subsequently, a third insulating layer 370 may be formed on the roof layer 360 using an inorganic insulating material such as silicon nitride (SiNx) and/or silicon oxide (SiOx). The third insulating layer 370 is formed on the patterned roof layer 360 to cover and protect the sides of the roof layer 360.

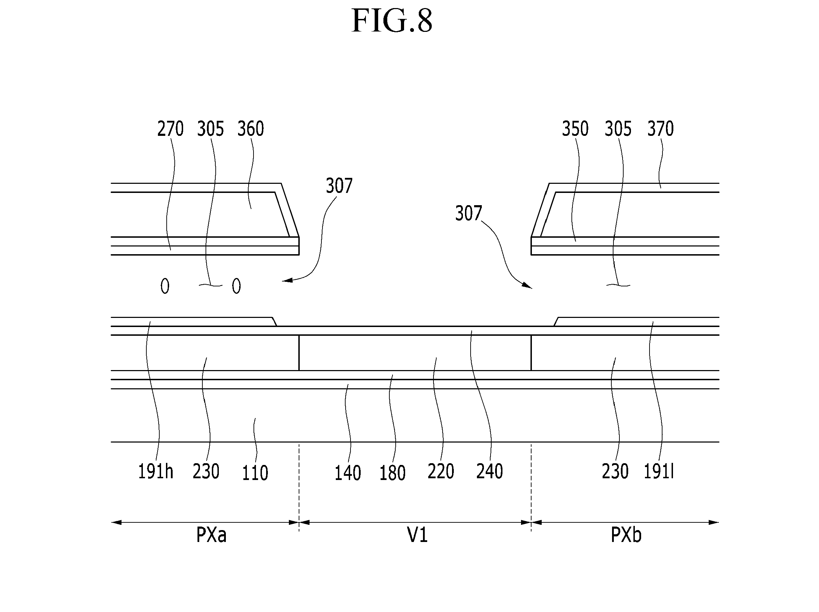

As illustrated in FIG. 8, portions of the third insulating layer 370, the second insulating layer 350, and the common electrode 270 that are positioned at the first valley V1 are removed by patterning the third insulating layer 370, the second insulating layer 350, and the common electrode 270.

As a result, a portion of the sacrificial layer 300 positioned at the first valley V1 is exposed.

Subsequently, the sacrificial layer 300 is fully removed by supplying a developer onto the substrate 110 where the sacrificial layer 300 is exposed. Alternatively or additionally, the sacrificial layer 300 may be fully removed using an ashing process.

After the sacrificial layer 300 has been removed, the microcavity 305 is formed at a space where the sacrificial layer 300 was positioned.

The pixel electrode 191 and the common electrode 270 are spaced apart from each other with the microcavity 305 being disposed therebetween, and the pixel electrode 191 and the roof layer 360 are spaced apart from each other with the microcavity 305 being disposed therebetween. The common electrode 270 and the roof layer 360 may cover the top and at least two lateral sides (not parallel to the top) of the microcavity 305.

The microcavity 305 is exposed through at least an opening positioned where the roof layer 360 and the common electrode 270 are removed, which is called a liquid crystal injection hole 307. A liquid crystal injection hole 307 may be formed along the first valley V1. Two injection holes 307 formed at the edges of the first subpixel area PXa and the second subpixel area PXb may face each other. An injection hole 307 may correspond to a lower side of the first subpixel area PXa to allow access to a first portion of the microcavity 305 that overlaps the first subpixel electrode 191h. An injection hole 307 may correspond to the upper side of the second subpixel area PXb allow access to a second portion of the microcavity 305 that overlaps the second subpixel electrode 1911 In an embodiment, a liquid crystal injection hole 307 may also be formed along the second valley V2.

Subsequently, the roof layer 360 is cured (or set in shape) by applying heat to the substrate 110. As a result, the shape of the microcavity 305 may be substantially maintained by the roof layer 360.

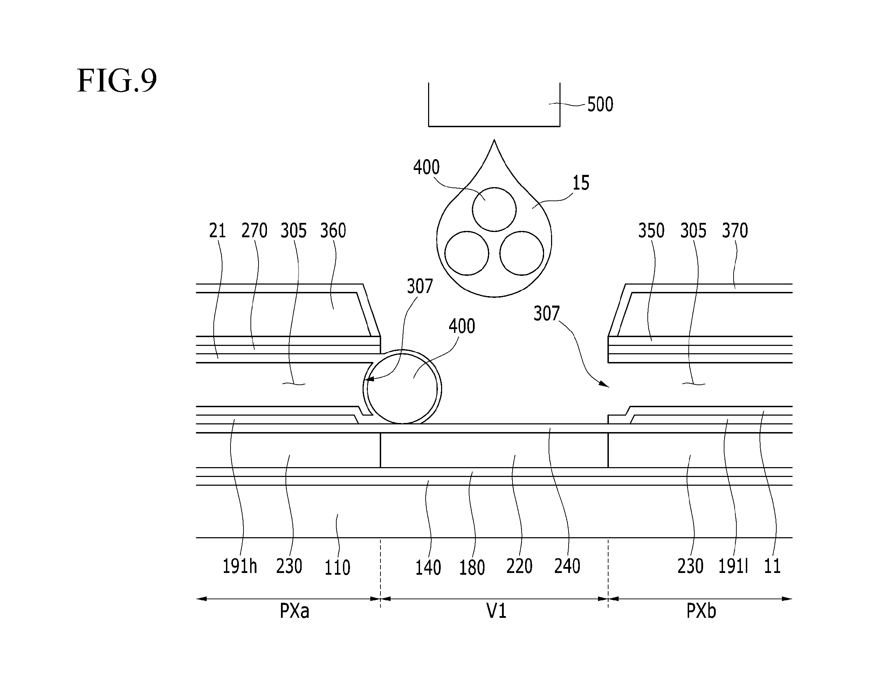

Subsequently, as illustrated in FIG. 9, a mixture that includes an alignment material 15 and bead members 400 is dropped and/or supplied onto the substrate 110 through an inkjet nozzle 500. In an embodiment, the mixture may be dropped at the first valley V1 on the substrate 110.

A substantial portion of the alignment material 15 is provided (e.g., injected) into the microcavity 305 through at least two injection holes 307 that face each other and are positioned at two edges of the first valley V1. The portion of the alignment material 15 may move into the microcavity 305 through a capillary action in an inward direction of the microcavity 305.

The capillary action in the inward direction of the microcavity 305 may also affect the bead members 400 mixed in the alignment material 15. Accordingly, the bead members 400 may move to the injection holes 307. As a result, a portion of a bead member 400 may be inserted into the microcavity 305. In an embodiment, the diameter of a bead member 400 is equal to or larger than the height of the microcavity 305; therefore, the bead member 400 may be stuck at the injection hole 307, such that a portion of the bead member 400 may be positioned inside the microcavity 305 without substantially reaching a display area of the display device and such that a remaining portion of the bead member may remain outside the microcavity 305.

As bead members 400 are positioned at the injection holes 307, edges of the roof layer 360 may be supported. Advantageously, the roof layer 360 may be prevented from sagging.

In an embodiment, the diameter of a bead member 400 may be minimized, such that the size (or volume) of the portion of a bead member 400 positioned inside the microcavity 305 may be only slightly smaller than and may approximate the size (or volume) of the portion of the bead member 400 positioned outside the microcavity 305. Advantageously, material required for producing the bead may be minimized, and the bead member 400 may be substantially stably positioned at the injection hole 307. In an embodiment, the diameter of the bead member 400 may approximate the height of the microcavity 305. In an embodiment, the diameter of the bead member 400 may be equal to or smaller than 110% of the height of the microcavity 305 (i.e., the height of the microcavity 305 multiplied by 110%).

An area or proportion of an injection hole 307 that is blocked by bead members 400 may depend on the amount of the bead members 400 mixed in the alignment material 15. In an embodiment, the amount of the bead member 400 may be controlled so that the bead members 400 may not block the entire region of the injection hole 307. In a subsequent process, liquid crystal material may be injected through the open (or unblocked) portions of the injection hole 307 into the corresponding portion of the microcavity 305. In an embodiment, the area of an injection hole 307 that is blocked by bead members 400 may be in a range of 1% to 80% of the entire area of the injection hole 307.

After an appropriate amount of the alignment material 15 has been disposed in the microcavity 305, a curing process may be performed, and a solution component is evaporated. As a result, the appropriate amount of the alignment material may remain on an inner wall of the microcavity 305.

Accordingly, the first alignment layer 11 may be formed on the pixel electrode 191, and the second alignment layer 21 may be formed on the common electrode 270. The first alignment layer 11 and the second alignment layer 21 may overlap each other with the microcavity 305 being disposed therebetween. The first alignment layer 11 and the second alignment layer 21 may be physically connected to each other at an edge of the pixel area PX, at an edge of a subpixel area, at an injection hole 307, and/or at a surface of a bead member 400.

In an embodiment, the alignment layers 11 and 21 may be configured to substantially align liquid crystal molecules in a vertical direction that is substantially perpendicular to the substrate 110 (i.e., perpendicular to a surface of the substrate 110 that overlaps the roof layer 360, except, for example, at positions where bead members 400 are located. In an embodiment, a process of irradiating UV light on the alignment layers 11 and 21 may be performed; as a result, the alignment layers 11 and 21 may be configured to substantially align liquid crystal molecules in a horizontal direction that is substantially parallel to the substrate 110.

Subsequently, liquid crystal material may be provided (e.g., dropped) on the substrate 110 using an inkjet method or a dispensing method. The liquid crystal material may be injected into the microcavity 305 through open portions of the injection holes 307. The injection holes 307 are partially blocked by bead members 400, and the liquid crystal material may be injected through open portions of the injection holes that are not blocked by the bead members 400.

In an embodiment, liquid crystal material may be provided through the injection holes 307 formed along odd-numbered first valleys V1 without being provided through the injection holes 307 formed along the even-numbered first valleys V1. In an embodiment, liquid crystal material may be provided through the injection holes 307 formed along the even-numbered first valleys V1 without being provided through the injection holes 307 formed along the odd-numbered first valleys V1.

In an embodiment, liquid crystal material is provided through the liquid crystal injection holes 307 formed along a first first valley V1 (i.e., a first first-type valley V1), the liquid crystal material may enter the liquid crystal injection hole 307 through capillary action into the microcavity 305. As the liquid crystal material enters into the microcavity 305, the liquid crystal material may push the air in the microcavity 305 such that the air may be discharged through the liquid crystal injection holes 307 formed along a second first valley V1 (i.e., a second first-type valley). The second first valley V1 may immediately neighbor the first first valley V1.

In an embodiment, liquid crystal material may be provided through all the liquid crystal injection holes 307. In an embodiment, liquid crystal material may be provided through the injection holes 307 formed along the odd-numbered first valleys V1 and the injection holes 307 formed along the even-numbered first valleys V1.

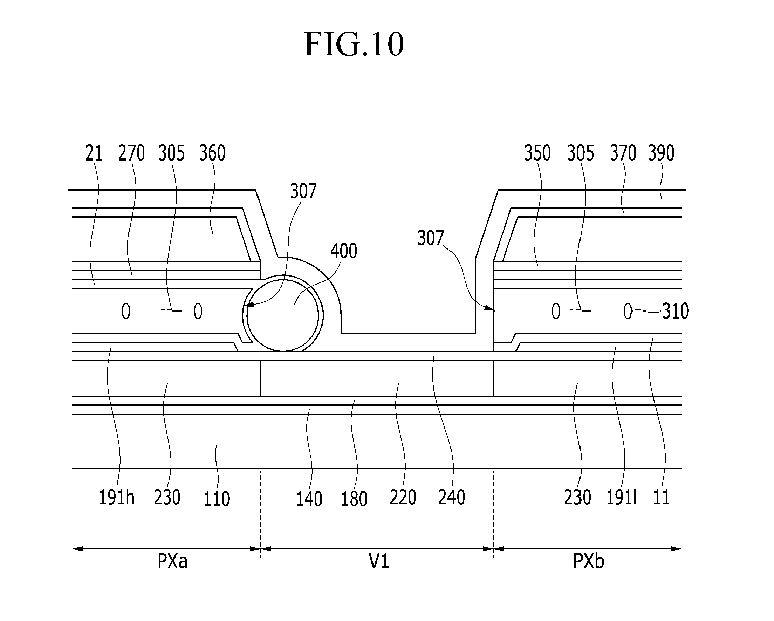

As illustrated in FIG. 10, an encapsulation layer 390 is formed by depositing a material that does not substantially chemically react with the liquid crystal molecules 310 on the third insulating layer 370. The encapsulation layer 390 is formed to cover the liquid crystal injection hole 307, for completely sealing the microcavity 305. The encapsulation layer 390 may cover the bead members 400.

In an embodiment of the present invention, the bead members 400 partially block the partial region of the injection hole 307, such that material of the encapsulation layer 390 is less likely to enter the microcavity 305. If the injection hole 307 were completely unblocked, in order to prevent the material of the encapsulation layer 390 from penetrating into the microcavity 305, the material of the encapsulation layer 390 might need to have a sufficiently high viscosity. If the viscosity of the material of the encapsulation layer 390 were substantially high, flatness and/or thickness of the encapsulation layer 390 might not be sufficiently uniform. In an embodiment of the present invention, since the injection hole 307 is partially blocked by the bead member 400, the viscosity of the encapsulation layer 390 may be substantially minimized. Advantageously, the encapsulation layer 390 may be satisfactorily uniform. In an embodiment, the viscosity of the material of the encapsulation layer 390 may be 1000 cp or less. In an embodiment, the viscosity of the material of the encapsulation layer 390 may be in a range of 30 cp to 100 cp. Advantageously, the encapsulation layer 390 may have satisfactory uniformity.

Subsequently, although not illustrated, a first polarizer may be attached onto the lower surface of the substrate 110, and a second polarizer may be attached onto the encapsulation layer 390.

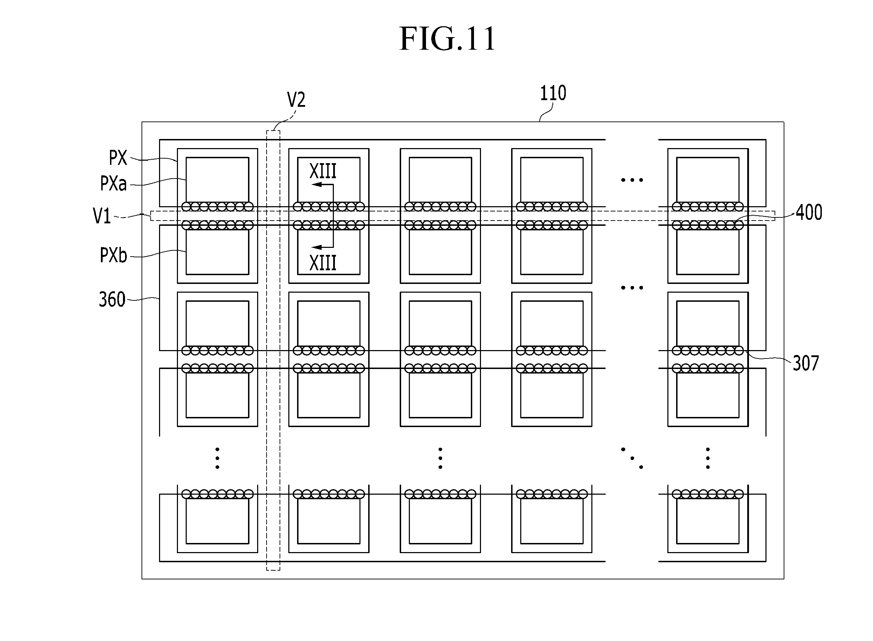

A display device according to an embodiment of the present invention is described below with reference to FIGS. 11 to 13.

Features and advantages of the display device and/or the embodiments described with reference to FIGS. 11 to 13 may be analogous to features and advantages of the display device and/or the embodiments described with reference to FIGS. 1 to 10. Therefore, redundant description may be omitted. In embodiments described with reference to FIGS. 11 to 13, bead members may be mixed with a liquid crystal material, instead of being mixed with an alignment material, in a display device manufacturing process.

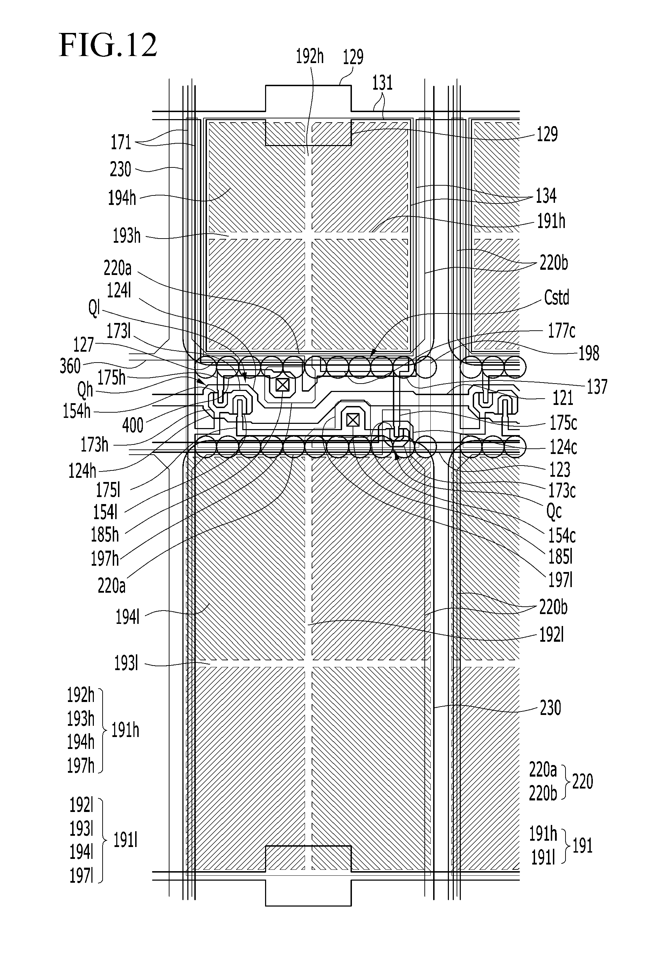

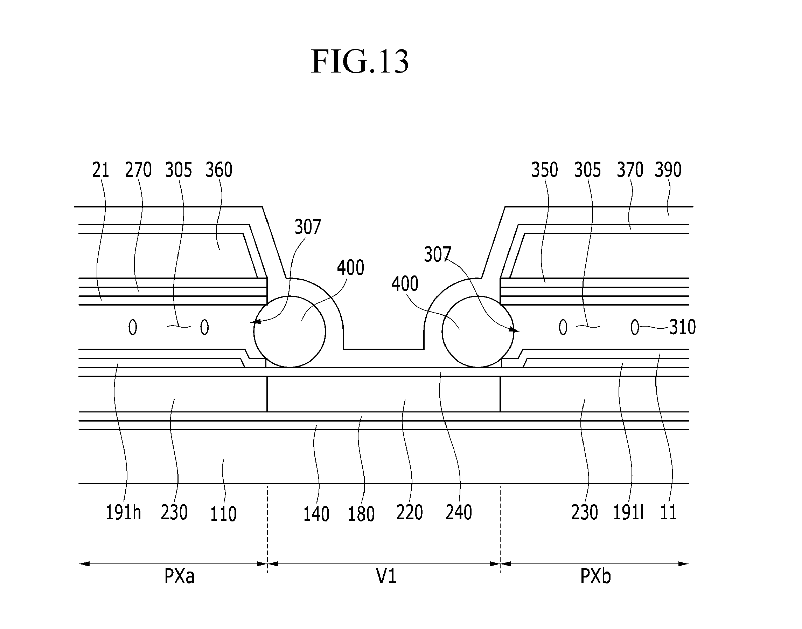

FIG. 11 is a plan view illustrating a display device according to an embodiment of the present invention. FIG. 12 is a plan view illustrating one pixel of the display device according to an embodiment of the present invention. FIG. 13 is a cross-sectional view illustrating a part of the display device taken along line XIII-XIII indicated in FIG. 11 according to an embodiment of the present invention.

Referring to FIGS. 11 to 13, in the display device, a thin film transistor and a pixel electrode 191 connected to the thin film transistor are formed on a substrate 110. A roof layer 360 overlaps the pixel electrode 191. A microcavity 305 is disposed between the roof layer 360 and the pixel electrode 191. A liquid crystal layer that includes liquid crystal molecules 310 is formed in the microcavity 305. An encapsulation layer 390 is formed on the roof layer 360 to seal the microcavity 310.

The microcavity 305 is exposed outside by the injection hole 307, and bead members 400 are provided at the injection hole 307. In an embodiment, the bead member 400 has a globular shape, a part of the bead member 400 is positioned in the microcavity 305, and the rest of the bead member 400 is positioned outside the microcavity 305.

The bead member 400 may be fixed (or stuck) to the injection hole 307 to support edges of the roof layer 360. Advantageously, a robust structure of the display device may be provided.

The diameter of each bead member 400 may be equal to or larger than the height of the microcavity 305. In an embodiment, the diameter of a bead member 400 may be equal to or smaller than 110% of the height of the microcavity 305.

In an embodiment, the bead members 400 may not be substantially covered by alignment material. In an embodiment, in the process of forming the liquid crystal layer, the liquid crystal material and the bead members 400 are mixed with each other, and the mixture is supplied to the injection hole 307. As a result, the bead members 400 are stuck at the injection hole 307, and a substantial portion of the liquid crystal material is injected (or provided) into the microcavity 305. Accordingly, a part of the bead member 400 positioned inside the microcavity 305 may directly contact the liquid crystal material. A portion of the liquid crystal material may remain on the part of the bead member 400 positioned outside of the microcavity 305 and may be removed by a cleaning process.

As the bead members 400 are stuck in the injection hole 307, the bead member 400 may block a partial region or the entire region of the injection hole 307. In an embodiment, the region of the injection hole 307 blocked by the bead members 400 may be in a range of 1% to 80% of the entire area of the injection hole 307.

In an embodiment, the area of the injection hole 307 that is blocked by bead members 400 may be in a range of 80% to 100% of the entire area of the injection hole 307. That is, the bead member 400 may block most of the injection hole 307. Accordingly, the bead member 400 may prevent the liquid crystal molecules 310 from being exposed. Accordingly, since the bead members 400 may substantially block the material of the encapsulation layer 390 from entering the microcavity 305, the viscosity of the material of the encapsulation layer 390 may be substantially minimized. In an embodiment, the viscosity of the material of the encapsulation layer 390 may be 1000 cp or less. In an embodiment, the viscosity of the material of the encapsulation layer 390 may be in a range of 30 cp to 100 cp.

In an embodiment, bead members 400 may be formed in a region between two injection holes 307 that face each other. In an embodiment, bead members 400 may be formed at the center of a first valley V1 in addition to edges of the first valley V1. In an embodiment, bead members 400 may fill substantially the entire region of the first valley V1 and may compensate for the thickness of the display device at the first valley V1, such that the difference between the thickness of the display device at the first valley V1 and the thickness of the display device at the pixel area PX (i.e., the subpixel area PXa and/or the subpixel area PXb) may be decreased.

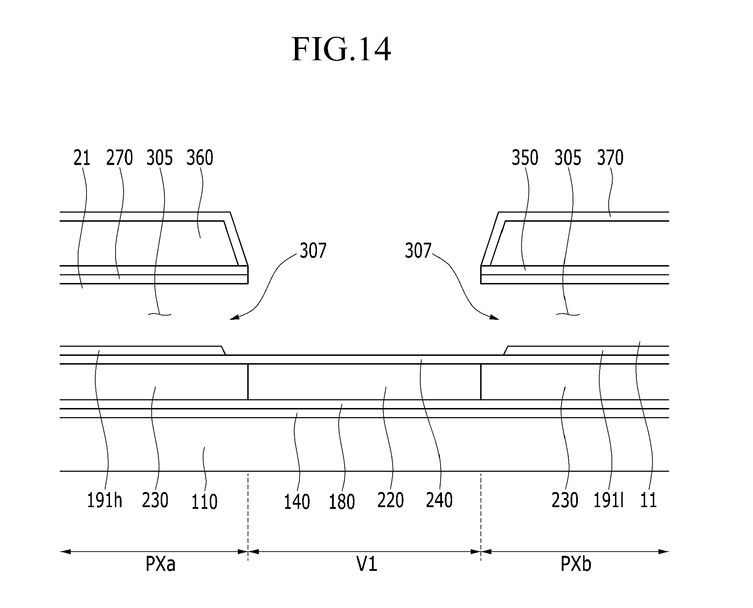

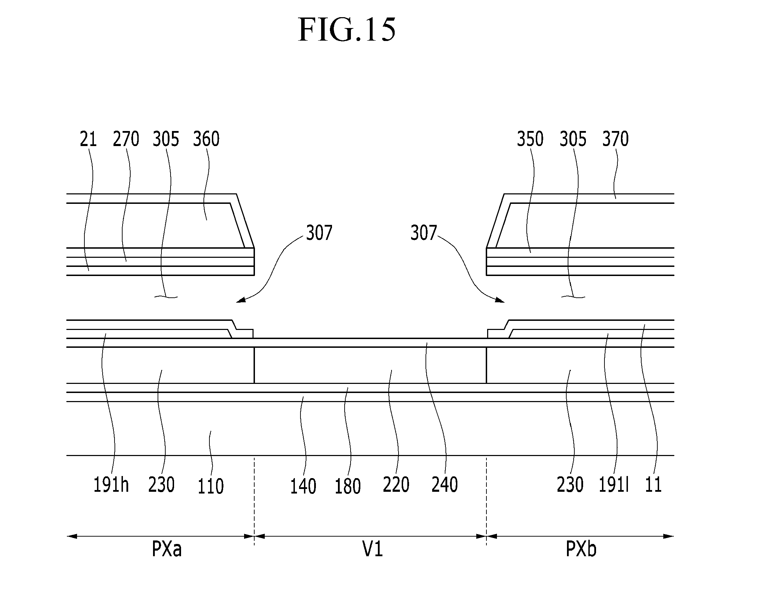

FIGS. 14 to 17 are process cross-sectional views illustrating a method for manufacturing the display device described with reference to FIGS. 11-13 according to an embodiment of the present invention.

On a substrate 110, thin film transistors Qh, Ql, and Qc and subpixel electrodes 191h and 1911 are formed. A sacrificial layer is formed on the subpixel electrodes 191h and 1911, and injection holes 307 may be formed by (sequentially) forming and patterning the common electrode 270, the second insulating layer 350, the roof layer 360, and the third insulating layer 370. The microcavity 305 is formed by removing the sacrificial layer.

An aligning agent that contains an alignment material is provided (e.g., dropped) on the substrate 110, the aligning agent is provided (e.g., injected) into the microcavity 305 through the liquid crystal injection hole 307. After the aligning agent has been provided in the microcavity 305, a curing process may be performed, a solution component may be evaporated, and the alignment material may remain on an inner wall of the microcavity 305.

Accordingly, the first alignment layer 11 may be formed on the pixel electrode 191, and the second alignment layer 21 may be formed on the common electrode 270. The first alignment layer 11 and the second alignment layer 21 may overlap each other with the microcavity 305 being disposed therebetween. The alignment layers 11 and 21 may be connected to each other at an edge of the pixel area PX.

In an embodiment, the alignment layers 11 and 21 may be configured to substantially align liquid crystal molecules in a vertical direction that is substantially perpendicular to the substrate 110 (i.e., perpendicular to a surface of the substrate 110 that overlaps the roof layer 360, except, for example, at positions where bead members 400 are located. In an embodiment, a process of irradiating UV light on the alignment layers 11 and 21 may be performed; as a result, the alignment layers 11 and 21 may be configured to substantially align liquid crystal molecules in a horizontal direction that is substantially parallel to the substrate 110.

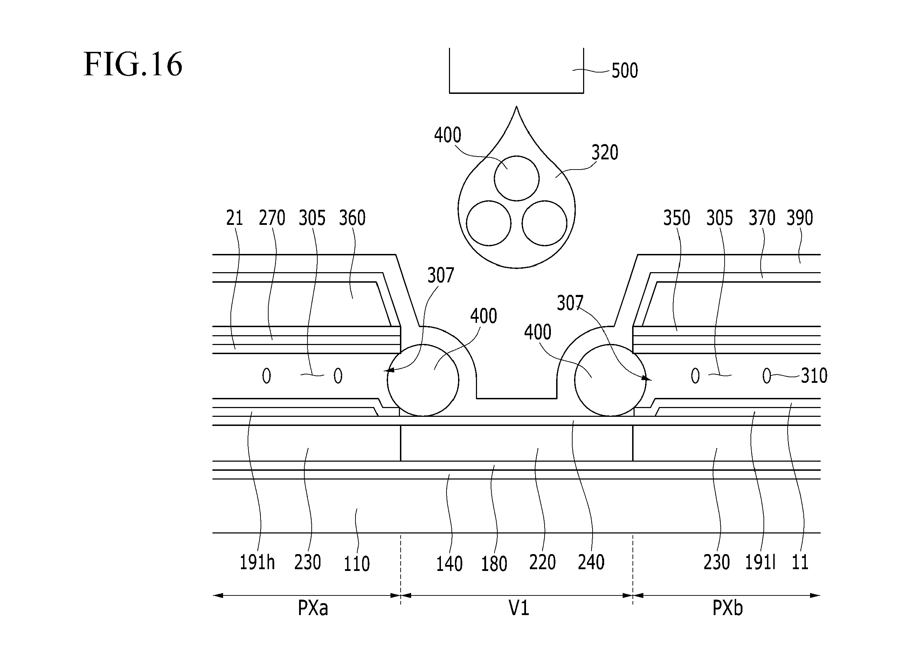

As illustrated in FIG. 16, a mixture that includes a liquid crystal material 320 and bead members 400 may be dropped and/or supplied onto the substrate 110 through an inkjet nozzle 500. In an embodiment, the mixture may be dropped in the first valley V1 on the substrate 110.

A substantial portion of the liquid crystal material 320 is provided (e.g., injected) into the microcavity 305 through at least two injection holes 307 that face each other and are positioned at two edges of the first valley V1. The portion of the liquid crystal material 320 may move into the microcavity 305 through a capillary action in an inward direction of the microcavity 305.

The capillary action in the inward direction of the microcavity 305 may also affect the bead members 400 mixed in the liquid crystal material 320. Accordingly, the bead members 400 may move to the injection hole 307.

As a result, a portion of a bead member 400 may be inserted into the microcavity 305. In an embodiment, the diameter of a bead member 400 is equal to or larger than the height of the microcavity 305; therefore, the bead member 400 may be stuck at the injection hole 307, such that a portion of the bead member 400 may be positioned inside the microcavity 305 without substantially reaching a display area of the display device and such that a remaining portion of the bead member may remain outside the microcavity 305.

As bead members 400 are positioned at the injection holes 307, edges of the roof layer 360 may be supported. Advantageously, the roof layer 360 may be prevented from sagging.

In an embodiment, the diameter of a bead member 400 may be minimized, such that the size (or volume) of the portion of a bead member 400 positioned inside the microcavity 305 may be only slightly smaller than and may approximate the size (or volume) of the portion of the bead member 400 positioned outside the microcavity 305. Advantageously, material required for producing the bead may be minimized, and the bead member 400 may be substantially stably positioned at the injection hole 307. In an embodiment, the diameter of the bead member 400 may approximate the height of the microcavity 305. In an embodiment, the diameter of the bead member 400 may be equal to or smaller than 110% of the height of the microcavity 305 (i.e., the height of the microcavity 305 multiplied by 110%).

An area or proportion of an injection hole 307 that is blocked by bead members 400 may depend on the amount of the bead members 400 mixed in the alignment material 15. In an embodiment, the amount of the bead member 400 may be controlled so that the bead members 400 may not block the entire region of the injection hole 307. In a subsequent process, liquid crystal material may be injected through the open (or unblocked) portions of the injection hole 307 into the corresponding portion of the microcavity 305. In an embodiment, the area of an injection hole 307 that is blocked by bead members 400 may be in a range of 1% to 80% of the entire area of the injection hole 307.

In an embodiment, the ratio of the bead members 400 and the alignment material 15 or the amount of the bead members 400 may be configured such that the bead members 400 may substantially block the entire injection hole 307.

In an embodiment, the amount of the bead member 400 may be configured such that the area of the injection hole 307 that is blocked by the bead members 400 may be in a range of 80% to 100% of the entire area of the injection hole 307. That is, the bead member 400 blocks most of the injection hole 307; as a result, the bead members 400 may prevent the liquid crystal molecules 310 may be prevented from leaking and/or being exposed.

In an embodiment, the bead members 400 may fill substantially the entire region of the first valley V1.

In a process of providing the liquid crystal material 320 into the microcavity 305, a part of the liquid crystal material 320 dropped on the substrate 110 may not be provided into the microcavity 305 and may remain on the upper surface of the third insulating layer 370 and/or in the first valley V1. A cleaning process may be performed after the liquid crystal material 320 injection process to remove the part of the liquid crystal material 320 that remains outside the microcavity 305. In the cleaning process, the liquid crystal material 320 remaining on the upper surface of the third insulating layer 370 and in the first valley V1 may be substantially removed.

Since the bead members 400 may block most of the injection hole 307, the cleaning process is performed, to the bead members 400 may prevent the liquid crystal material 320 positioned inside the microcavity 305 from being removed.

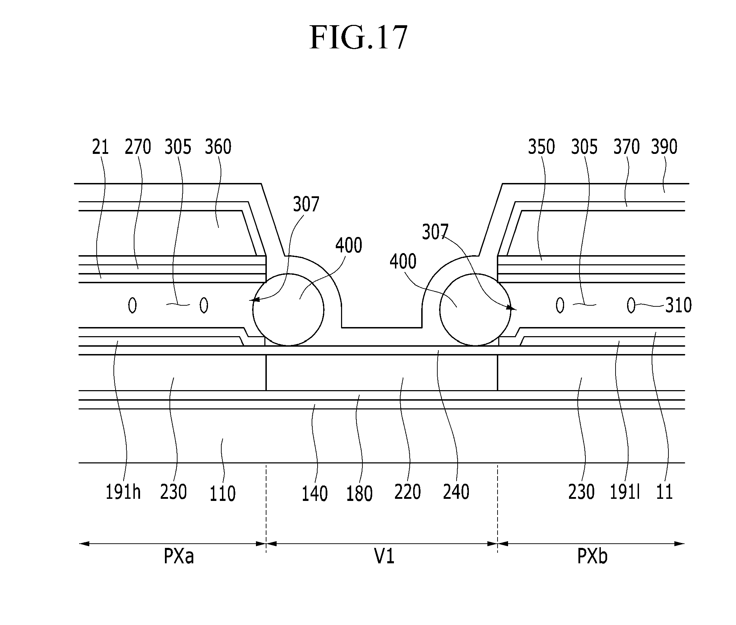

As illustrated in FIG. 17, an encapsulation layer 390 is formed by depositing a material that does not substantially (chemically) react with the liquid crystal molecules 310 on the third insulating layer 370. The encapsulation layer 390 is formed to cover the liquid crystal injection hole 307, for completely seal the microcavity 305. The encapsulation layer 390 may cover the bead members 400.

In an embodiment of the present invention, the bead members 400 partially block the partial region of the injection hole 307, such that material of the encapsulation layer 390 is less likely to enter the microcavity 305. If the injection hole 307 were completely unblocked, in order to prevent the material of the encapsulation layer 390 from penetrating into the microcavity 305, the material of the encapsulation layer 390 might need to have a sufficiently high viscosity. If the viscosity of the material of the encapsulation layer 390 were substantially high, flatness and/or thickness of the encapsulation layer 390 might not be sufficiently uniform. In an embodiment of the present invention, since the injection hole 307 is partially blocked by the bead member 400, the viscosity of the encapsulation layer 390 may be substantially minimized. Advantageously, the encapsulation layer 390 may be satisfactorily uniform. In an embodiment, the viscosity of the material of the encapsulation layer 390 may be 1000 cp or less. In an embodiment, the viscosity of the material of the encapsulation layer 390 may be in a range of 30 cp to 100 cp. Advantageously, the encapsulation layer 390 may have satisfactory uniformity.

Subsequently, although not illustrated, polarizers may be formed on the upper surface of the encapsulation layer 390 and the lower surface of the substrate 110.

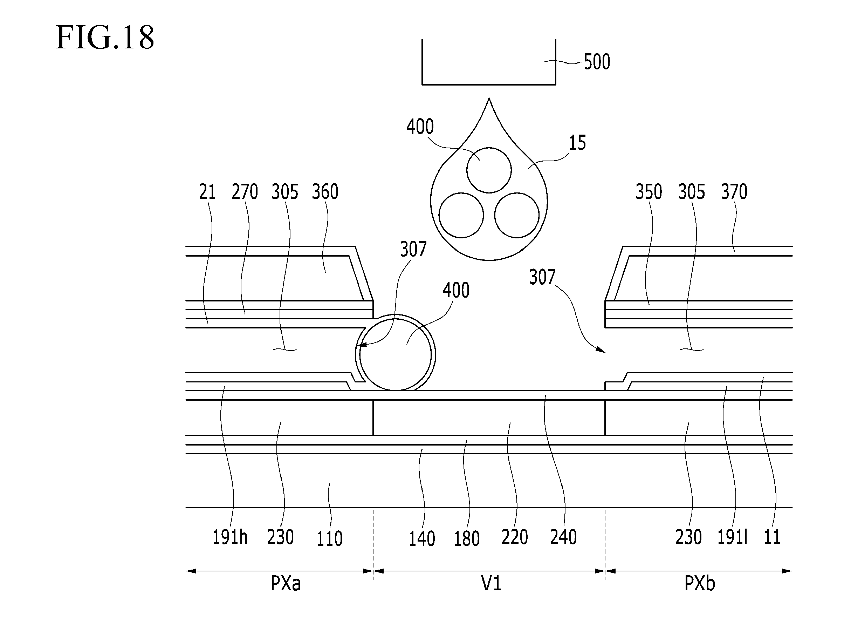

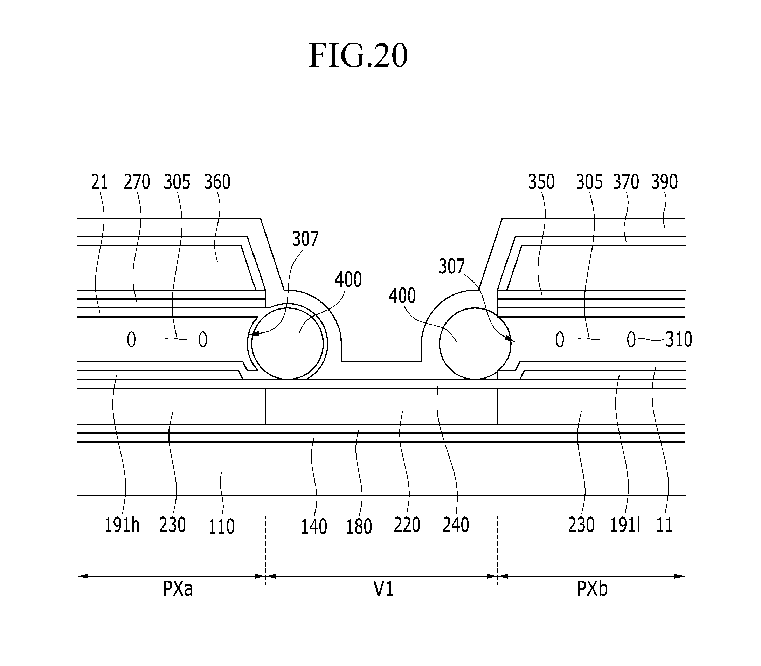

A manufacturing method of a display device according to an embodiment of the present invention is described below with reference to FIGS. 18 to 20.

Steps and advantages of the manufacturing method and/or embodiments described with reference to FIGS. 18 to 20 may be analogous to steps and advantages of the manufacturing method and/or embodiments described with reference to one or more of FIGS. 1 to 17. Therefore, redundant description may be omitted. In embodiments described with reference to FIGS. 18 to 20, some bead members may be mixed with a liquid crystal material, and some bead members may be mixed with an alignment material.

FIGS. 18 to 20 are process cross-sectional views illustrating a manufacturing method of a display device according to an embodiment of the present invention.

On a substrate 110, thin film transistors and subpixel electrodes 191h and 1911 are formed. A sacrificial layer is formed on the subpixel electrodes 191h and 1911, and injection holes 307 may be formed by (sequentially) forming and patterning the common electrode 270, the second insulating layer 350, the roof layer 360, and the third insulating layer 370. The microcavity 305 is formed by removing the sacrificial layer.

Subsequently, a mixture that includes an alignment material 15 and bead members 400 may be dropped and/or supplied onto the substrate 110 through an inkjet nozzle 500. In an embodiment, the mixture may be dropped at the first valley V1 on the substrate 110.

A substantial portion of the alignment material 15 is provided (e.g., injected) into the microcavity 305 through at least an injection hole 307, and bead members 400 may be positioned at the injection hole 307. A diameter of each bead member 400 may approximate and may be larger than the height of the microcavity 305. The amount of the bead member 400 may be configured such that the bead members 400 may partially block the injection hole 307 without blocking the entire region of the injection hole 307.

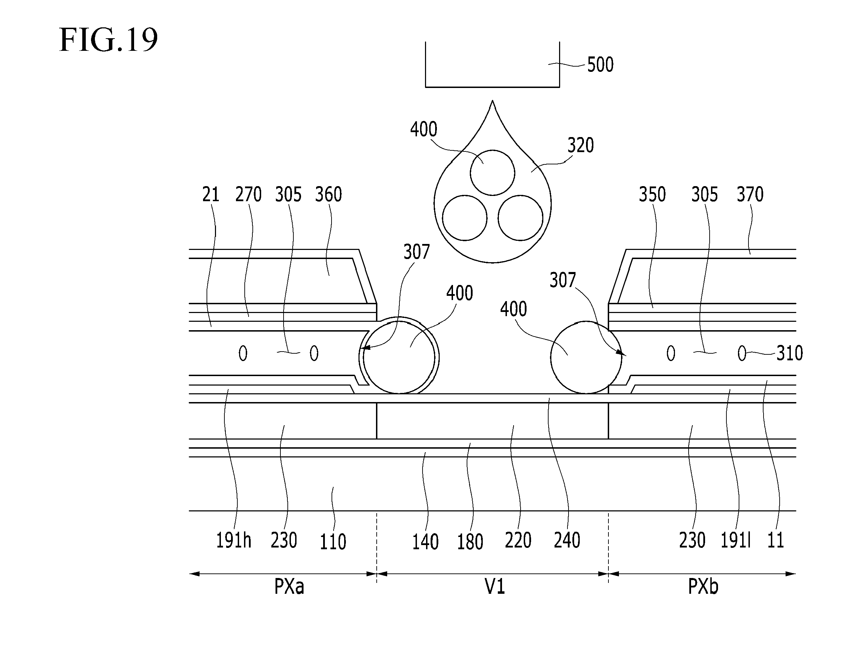

As illustrated in FIG. 19, a mixture that includes a liquid crystal material 320 and bead members 400 may be dropped and/or supplied onto the substrate 110 through an inkjet nozzle 500. In an embodiment, the mixture may be dropped at the first valley V1 on the substrate 110.

A substantial portion of the liquid crystal material 320 is provided (e.g., injected) into the microcavity 305 through the injection hole 307, and bead members 400 may be positioned in the injection hole 307. A diameter of each bead member 400 may approximate and may be larger than the height of the microcavity 305. The amount of the bead members 400 may be configured such that the bead members 400 provided in the step illustrated in FIG. 18 and the bead members 400 provided in the step illustrated in FIG. 19 may block most of the injection hole 307.

Subsequently, a cleaning process may be performed to remove a portion of the liquid crystal material 320 that remain outside the microcavity 305.

An encapsulation layer 390 is formed by depositing a material that does not substantially (chemically) react with the liquid crystal molecules 310 on the third insulating layer 370.

Subsequently, although not illustrated, polarizers may be further formed on the upper surface of the encapsulation layer 390 and the lower surface of the substrate 110.

As can be appreciated from the description, embodiments of the invention may require only one substrate. Advantageously, the thickness, weight, and/or cost associated with a display device may be minimized.

While this invention has been described in connection with what is presently considered to be practical embodiments, it is to be understood that the invention is not limited to the disclosed embodiments. This invention is intended to cover various modifications and equivalent arrangements included within the spirit and scope of the appended claims.

**<Description of symbols>**

| | | | |
|---|---|---|---|
| 11: First alignment layer | | 15: Alignment material | |
| 21: Second alignment layer | | | 110: Substrate |
| 121: Gate line | | | 123: Step-down gate line |
| 124h: First gate electrode | | | 124l: Second gate electrode |
| 124c: Third gate electrode | | | 131: Storage electrode line |
| 140: Gate insulating layer | | | 154h:First semiconductor |
| 154l: Second semiconductor | | | 154c: Third semiconductor |
| 171: Data line | | | 173h: First source electrode |
| 173l: Second source electrode | | 173c: Third source electrode | |
| 175h: First drain electrode | | | 175l: Second drain electrode |
| 175c: Third drain electrode | | | 180: Passivation layer |
| 191: Pixel electrode | | | 191h: First subpixel electrode |
| 191l: Second subpixel electrode | | 220: Light blocking member | |
| 230: Color filter | | 240: First insulating layer | |
| 270: Common electrode | | 300: Sacrificial layer | |
| 305: Microcavity | | | 307: Injection hole |
| 310: Liquid crystal molecule | | | 320: Liquid crystal material |
| 350: Second insulating layer | | | 360: Roof layer |
| 370: Third insulating layer | | | 390: Encapsulation layer |
| 400: Bead member | | | |

## Claims

1. A display device comprising:
a substrate including a plurality of pixel areas;
a thin film transistor disposed on the substrate;
a pixel electrode electrically connected to the thin film transistor and disposed in the pixel area;
a roof layer overlapping the pixel electrode with a plurality of microcavities being positioned between the roof layer and the pixel electrode, the microcavity having an injection hole;
an alignment layer disposed inside the microcavity;
a liquid crystal layer disposed inside the microcavity;
a plurality of bead members disposed at the injection hole; and
an encapsulation layer overlapping the roof layer and overlapping the plurality of bead members.

2. The display device of claim 1, wherein a diameter of the bead member is equal to or larger than a height of the microcavity.

3. The display device of claim 2, wherein
the diameter of the bead member is equal to or smaller than 110% of the height of the microcavity.

4. The display device of claim 1, wherein
an area of the injection hole blocked by the plurality of bead members is in a range of 1% to 80% of the entire area of the injection hole.

5. The display device of claim 1,
further comprising an alignment material layer formed of an alignment material used for forming the alignment layer, disposed outside the microcavity, and covering the plurality of bead members.

6. The display device of claim 1, wherein
an area of the injection hole blocked by the plurality of bead members is in a range of 80% to 100% of the entire area of the injection hole.

7. The display device of claim 1, wherein the plurality of bead members is further disposed between the plurality of microcavities.

8. The display device of claim 1, wherein
viscosity of an encapsulation layer material used for forming the encapsulation layer is 1000 cp or less.

9. The display device of claim 8, wherein
the viscosity of the encapsulation layer material is in a range of 30 cp to 100 cp.
